Europäisches Patentamt

(19) European Patent Office

Office européen des brevets

(11) Publication number : **0 456 419 A2**

## (12) EUROPEAN PATENT APPLICATION

(21) Application number : 91303994.7

(51) Int. Cl.⁵ : **H03K 19/003**

(22) Date of filing : 02.05.91

(30) Priority : 07.05.90 US 520005

(43) Date of publication of application :
13.11.91 Bulletin 91/46

(84) Designated Contracting States :
DE FR GB

(71) Applicant : **NCR CORPORATION**
**World Headquarters**
**Dayton, Ohio 45479 (US)**

(72) Inventor : **Donahue, James A.**
**3216 6th Avenue South**
**Great Falls, Montana 59405 (US)**

(74) Representative : **Robinson, Robert George**
**International Patent Department NCR Limited**
**915 High Road North Finchley**
**London N12 8QJ (GB)**

(54) Apparatus for driving a plurality of data output lines.

(57) An integrated circuit including an output driver circuit for sequentially driving a plurality of data lines (20 to 25), said output driver circuit includes a plurality of output buffers (OB0 to OB5), each output buffer having an input terminal for receiving bit data, an enable terminal (E0 to E5), and an output terminal. A tapped delay line formed of a chain of delay elements (D0 to D5) receives an enable signal and provides delayed versions of the enable signal to the enable terminals of the output buffers such that no two output buffers are enabled simultaneously.

EP 0 456 419 A2

# FIG. 1

The present invention relates to output drivers for integrated circuits.

Integrated circuits employed in computers are often required to output many signals at the same time, and as word and memory sizes increase, the number of output signals an IC must support also increases. For example, a thirty-two bit computer having a two mega-byte memory may require integrated circuits capable of driving more than fifty-three outputs simultaneously, providing thirty-two bits of data to a data bus and twenty-one bits of information to an address bus. If the address and data bus lines which the IC must support have large capacitive loadings, an attempt by the IC to drive so many outputs simultaneously may produce internal voltage level shifts causing memory cells to be corrupted or other output drivers to temporarily drive incorrect values. The likelihood of experiencing either of these undesirable results increases if the integrated circuit's output drivers must produce a large voltage swing on the data or address bus, such as is required by CMOS or TTL technologies.

In an integrated circuit, the exact number of drivers to be enabled at any instant would depend on the load each must support. Over a short period of time all of the output drivers would be fired, several at a time, until all the drivers were enabled. However, firing several outputs at a time increases the chance of crosstalk on the IC and in the board through which the output bus is routed and produces noise spikes on the power and ground buses of the IC affecting the integrated circuit's internal logic cells and other output drivers. If the spikes are large, they may cause logic cells to switch states or temporarily output wrong values. Such "glitches" are serious problems if they are requests for system resources or memory transfers.

An object of the present invention to provide a new and improved output driver circuit which is not subject to the foregoing disadvantages.

According to the present invention there is provided an integrated circuit including an output driver circuit for driving a plurality of data lines, said apparatus including a plurality of buffers, each buffer having an input terminal connected to a respective input line, an output terminal connected to a respective output line, and an enable terminal, said output terminal of each buffer being responsive to a signal received at its corresponding enable terminal to pass data received on its corresponding input line to its corresponding output line, characterized in that means are provided for sequentially applying an enable signal to each of said enable terminals of said buffers, such that no two buffers are enabled simultaneously.

The present invention has the advantage of avoiding the generation of the above mentioned glitches.

An embodiment of the present invention will be described with reference to the accompanying drawing wherein:

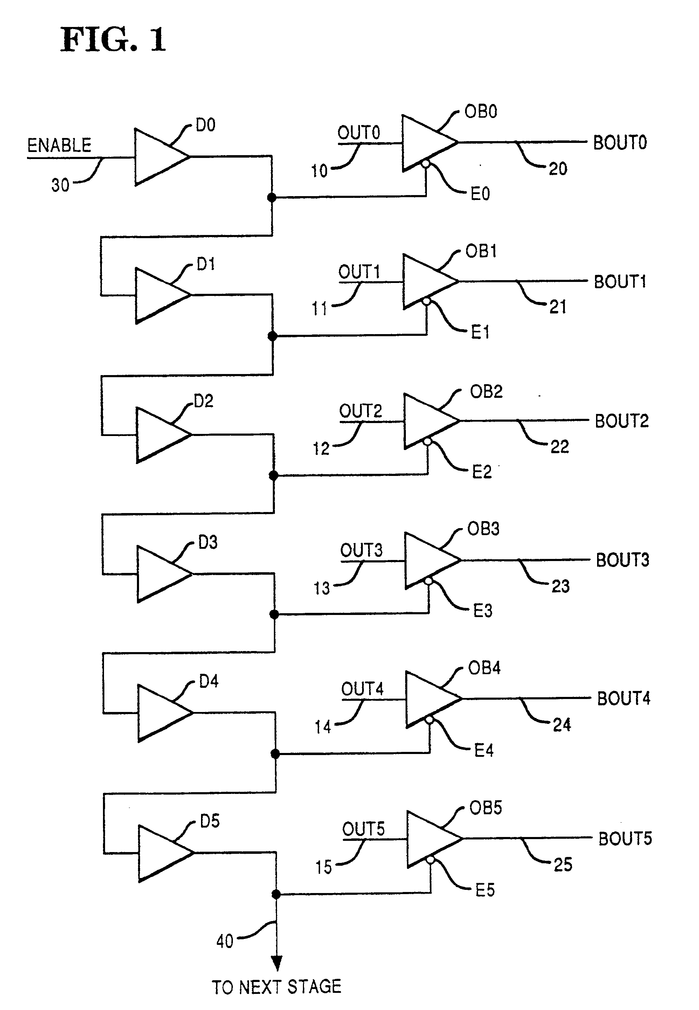

Fig. 1 is a block diagram of an output driver circuit in accordance with the present invention.

Referring now to Fig. 1, there is seen a plurality of output buffers OB0 through OB5 for an integrated circuit chip. Each output buffer receives an internal data output signal from circuitry within the chip (not shown) and produces at its output a buffered output signal which is provided to circuitry external to the chip. In addition to data input and buffered output terminals, output buffers OB0 through OB5 each include an enable signal input terminal, designated as E0 through E5, respectively, in FIG. 1. The output buffer circuitry thus far described with respect to FIG. 1 is well known to those skilled in the art.

The practice of the present invention according to FIG. 1 includes a plurality of delay buffers D0 through D5 connected together in series forming a chain of buffers. Each buffer includes an input for receiving a logic signal and an output for providing a delayed version of the received logic signal. Delay buffer D0, the first buffer in the delay chain, is connected to receive an ENABLE signal via conductor 30 from the circuitry within the integrated circuit chip. The output of delay buffer D0 is thereafter provided to the input of delay buffer D1, the second buffer in the delay chain. Each successive delay buffer in the chain is connected to receive as its input the output of the preceding delay buffer.

In addition to being connected to the inputs of the succeeding delay buffers, the outputs of delay buffers D0 through D5 are connected, in order, to enable terminals E0 through E5 of output buffers OB0 through OB5. Thus, as shown in FIG. 1, a single delay buffer, D0, is provided between conductor 30 and the enable terminal of output buffer OB0; two delay buffers, D0 and D1, are provided before enable terminal E1; three delay buffers, D0 through D2, before enable terminal E2: four delay buffers, D0 through D3, before enable terminal E3; five delay buffers, D0 through D4, before enable terminal E4; and all six delay buffers are connected in series between conductor 30 and the enable terminal for output buffer OB5.

Although six output buffers and six delay buffers are shown in FIG. 1, it should be understood that more or less output buffers and delay buffers may be included in the output buffer circuit of the present invention. For example, if the integrated circuit associated with the output buffer circuit produces a four byte word output then thirty-two output drivers would be required. Additional drivers for ECC, or error correcting code, outputs and address outputs may also be required. In the figure, the six output buffers represent the first six output buffers in the output buffer circuit. Similarly, the six delay buffers shown represent the first six buffers in the delay chain. Conductor 40 shown in FIG. 1 is provided to connect the output of delay buffer D5 to the next delay buffer in the chain.

In the preferred embodiment of the invention delay buffers D0 through D5 each produce an equal delay of, for example, 160 picoseconds. Therefore, the delays produced at the outputs of buffers D0 through D5 are 160pS, 320pS, 480pS, 640pS, 800pS and 960pS, respectively.

In operation, the internal circuitry of the integrated circuit simultaneously provides internal data output signals OUT0 through OUT5 via conductors 10 through 15 to output buffers OB0 through OB5, respectively, and the ENABLE signal via conductor 30 to delay buffer D0. After a first delay of 160pS, a delayed version of the ENABLE signal is provide to terminal E0, activating output buffer OB0 to provide a buffered version of signal OUT0, designated BOUT0 to output conductor 20. After a delay of 320pS, output buffer OB1 is enabled to provide signal BOUT1, a buffered version of signal OUT1, to output conductor 21. In sequence the remaining output buffers are activated to provide buffered signals BOUT2 through BOUT5 to output lines 22 through 25 after delays of 480pS, 640pS, 800pS and 960pS, respectively. All output buffers are active after 960pS. For most application it is important that the delay time be selected so that all output buffers are enabled, providing valid output signals within one clock cycle of the system which includes the delay circuit.

It can thus be seen that there has been provided by the present invention an output driver circuit which sequentially enables a plurality of output drivers so that no two output drivers are fired at the same instant, thus eliminating noise spikes and internal voltage swings within the associated logic circuitry. The output driver circuit and delay means comprises a plurality of output buffers and delay buffers which can readily be reduced for incorporation into an integrated circuit.

Although the presently preferred embodiment of the invention has been described, it will be understood that various changes may be made within the scope of the appended claims. For example, the order and timing of the firing of the output buffers can be varied. A delay buffer need not be connected before the enable terminal of output buffer OB0. This first output buffer can be connected to receive the undelayed version of the ENABLE signal. Furthermore, the circuitry described herein may be implemented in CMOS, TTL or other logic technologies.

Those skilled in the art will recognize that the invention is not limited to the specific embodiments described and illustrated. Other variations, changes, substitutions and equivalents are possible without departing from the spirit and scope of the present invention.

## Claims

1. An integrated circuit including an output driver circuit for driving a plurality of data lines (20 to 25), said apparatus including a plurality of buffers (OB0 to OB5), each buffer having an input terminal connected to a respective input line (10-15), an output terminal connected to a respective output line (20 to 25), and an enable terminal (E0 to E5), said output terminal of each buffer being responsive to a signal received at its corresponding enable terminal to pass data received on its corresponding input line to its corresponding output line, characterized in that means (D0 to D5) are provided for sequentially applying an enable signal to each of said enable terminals (E0 to E5) of said buffers, such that no two buffers are enabled simultaneously.

2. A circuit according to claim 1, characterized in that said means for sequentially applying an enable signal comprises a tapped delay line (D0 to D5) having an input (30) for receiving said enable signal and a plurality of outputs, said delay line outputs being respectively connected to the enable terminals (E0 to E5) of said output buffers (OB0 to OB5).

3. A circuit according to claim 2, characterized in that said tapped delay line comprises a plurality of delay elements (D0 to D5) connected together to form a chain, the first delay element (D0) in said chain being connected to receive said enable signal.

4. A circuit according to claim 3, characterized in that each of said delay elements (D0 to D5) retards the propagation of said enable signal by 160 picoseconds.

5. A circuit according to any preceding claim, characterized in that said output buffers OB0 to OB5) provide TTL level output signals.

# FIG. 1

ENABLE

D0

30

10 OUT0

OB0

E0

BOUT0

20

D1

11 OUT1

OB1

E1

BOUT1

21

D2

12 OUT2

OB2

E2

BOUT2

22

D3

13 OUT3

OB3

E3

BOUT3

23

D4

14 OUT4

OB4

E4

BOUT4

24

D5

15 OUT5

OB5

E5

BOUT5

25

40

TO NEXT STAGE